Europäisches Patentamt

European Patent Office

Office européen des brevets

(19)

(11) Publication number: 0 402 050
A2

## (12) EUROPEAN PATENT APPLICATION

(21) Application number: 90305949.1

(22) Date of filing: 31.05.90

(51) Int. Cl.⁵: H01P 11/00, H01P 3/08

(30) Priority: 05.06.89 GB 8912808

(43) Date of publication of application:
12.12.90 Bulletin 90/50

(84) Designated Contracting States:
AT BE CH DE DK ES FR GR IT LI LU NL SE

(71) Applicant: GEC-MARCONI LIMITED
The Grove Warren Lane
Stanmore Middlesex HA7 4LY(GB)

(72) Inventor: Macleod, Angus James Miller
Gadebrook, Hydewood Lane
Canewdon, Essex SS4 3RR(GB)

(74) Representative: Tolfree, Roger Keith et al
GEC-Marconi Research Centre West
Hanningfield Road
Great Baddow Chelmsford Essex CM2
8HN(GB)

(54) Triplate centre conductors.

(57) A method of forming a triplate centre conductor including the steps of forming the centre conductor core (5) from steel and plating the steel with a metal (6) which is more conductive than the core (5).

Fig 4

# TRIPLATE CENTRE CONDUCTORS

This invention relates to triplate centre conductors.

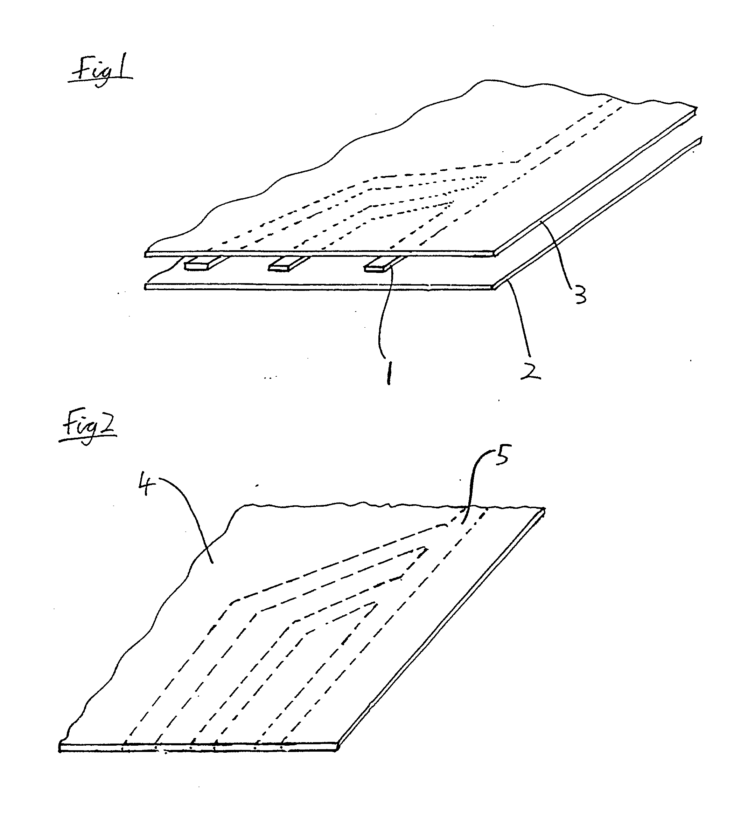

Triplates comprise a conductive centre conductor 1 supported between two conductive earth plates 2, 3 and equidistant from them as shown in Figure 1.

Generally in order to meet the physical requirements for accuracy and lightness and the triplates' electrical requirements the triplate centre conductor is formed from aluminium or copper sheet by etching or stamping. Both of these fabrication methods can cause problems; etching has problems due to material warp and shrinkage, while stamping requires the use of thick material to avoid distortion and in many triplate applications the use of a relatively thin centre conductor is desirable.

The use of copper and aluminium also causes problems because of the softness of these metals, it is very difficult to prevent distortion of either the initial copper or aluminium sheet or the completed triplate centre conductor due to bending during handling. Once such bending has occurred the centre conductor will be useless, and an economically unacceptable level of wastage will result unless thick centre conductors are used.

Various methods have been employed to overcome such problems particularly in large structures. These have comprised assembling small sections in situ, and either joining them directly together or by coaxial cable. These methods require expensive manufacturing techniques and usually result in a large loss factor for the resultant structure due to the number of connections made. For example fifteen connections between an input/output port and a transmitting/receiving element, each having an associated loss of 0.1 dB leads to a total loss after transmission and reception of 3 dB, half the power. In addition it is also difficult to obtain the precise paths lengths required using such methods.

One method employed to overcome the above problems comprises forming metal tracks on a thin substrate, the tracks either being formed by etching or deposition by known techniques. However this also gives unsatisfactory results, for the thickness of metal tracks which can be formed by such techniques is limited and in turn limits the power handling capabilities of the product. Also the distortion of certain substrate types resulted in inaccuracies in the dimensions of the centre conductor.

Laser cutting of copper and aluminium sheets is also unsatisfactory and does not overcome the difficulties experienced in handling the resultant structures.

This invention was intended to produce a triplate centre conductor at least partially overcoming these problems.

This invention provides a method of forming a triplate centre conductor including the steps of;

i) forming the centre conductor core from steel;

ii) plating the steel core with a metal which is more conductive than steel.

This has the advantage that the triplate centre conductor has the stiffness and resistance to physical damage of steel and as a result distortion in handling is greatly reduced. This enables larger, more intricate centre conductor shapes to be handled than was previously viable, and enables magnetic lifting means to be employed.

It is preferred to cut the centre conductor core from steel sheets by laser cutting because this allows very thin steel to be used, allowing the weight of the triplate structure to be kept low. Very large intricate centre conductors can be cut in this way from a single sheet, which require no further finishing before plating.

Advantageously the steel is corrosion resistant ensuring little degradation of the surface before plating and a long service life.

It is preferred to use aluminium or copper to plate the steel because of their electrical properties and it has been found convenient to plate them using electroplating.

This invention also provides a triplate structure including a centre conductor having a steel core coated with a metal more conductive than steel.

A method of producing triplate centre conductors embodying the invention will now be described with reference to the accompanying figures in which;

Figure 1 shows a first stage in the manufacture of a triplate centre conductor for a phased array antenna in schematic form;

Figure 2 shows a second stage in the manufacture of a triplate centre conductor for a phased array antenna in schematic form;

Figure 3 shows a third stage in the manufacture of a triplate centre conductor in schematic form, identical parts having the same reference numerals throughout.

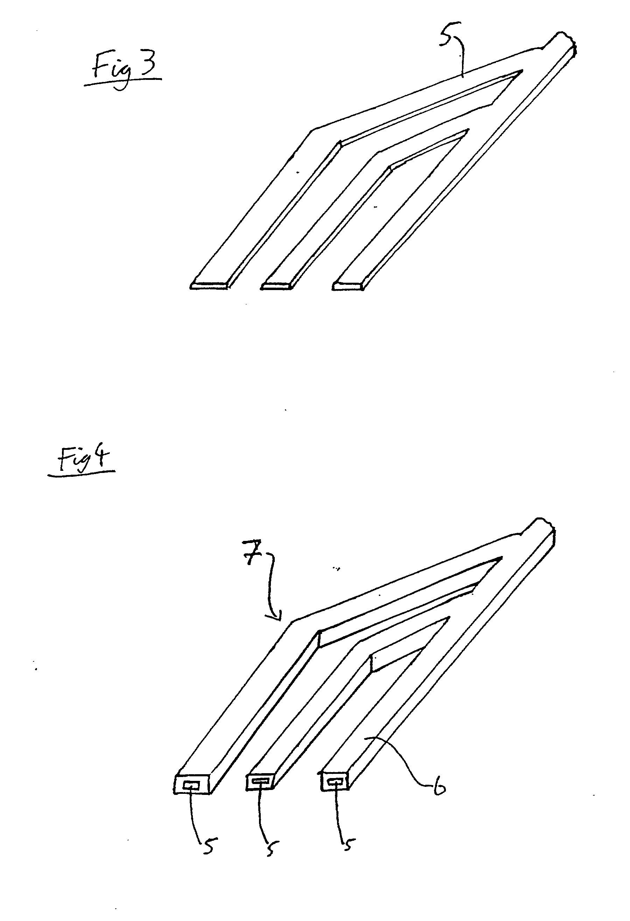

Referring to Figure 2 a corrosion resistant steel sheet 4 has the core 5 of a triplate centre conductor cut from it by a laser (not shown) which cuts along the dashed lines to produce a corrosion resistant steel triplate centre conductor core 5 as shown in Figure 3, for connecting a plurality of transmitting/receiving elements of a phased array antenna (not shown) to a common input/output terminal.

The steel triplate conductor core 5 is then electroplated with a layer of copper 6 to produce the completed triplate centre conductor 7, as shown in Figure 4. The average thickness of the copper plating is 10 - 15 μm ensuring that at every point the plating is in excess of the skin depth of 2 - 3 μm at 1 GHz.

The core 5 could of course be formed from the steel in any other manner such as milling or punching.

The steel triplate centre conductor core 5 could be plated by methods other than electroplating and could be plated with materials other than copper provided they had a higher conductivity than steel, for example aluminium.

The centre conductor core 5 could be formed from materials other than corrosion resistant steel provided they had acceptable physical properties. Most steels would be acceptable for at least some triplate applications.

**Claims**

1. A method of forming a triplate centre conductor including the steps of:

    i) forming a centre conductor core (5) from steel, and

    ii) plating the steel core with a metal (6) which is more conductive than steel.

2. A method as claimed in Claim 1 in which the centre conductor core is formed by laser cutting from steel sheet.

3. A method as claimed in Claim 1 or Claim 2 in which the steel is a corrosion resistant steel.

4. A method as claimed in any preceding claim in which the plating is electroplating.

5. A method as claimed in any preceding claim in which the more conductive metal is copper.

6. A method as claimed in any of Claims 1 to 4 in which the more conductive metal is aluminium.

7. A triplate centre conductor formed by the method of any one of the preceding claims.

8. A triplate structure including a centre conductor having a steel core coated with a metal more conductive than steel.

9. A triplate structure as claimed in Claim 8 in which the more conductive metal is copper.

10. A triplate structure as claimed in Claim 8 in which the more conductive metal is aluminium.

11. A phased array antenna comprising a triplate centre conductor formed by the method of any of Claims 1 to 6.

12. A phased array antenna comprising a triplate structure as claimed in any of Claims 8 to 10.

_Fig 1_

_Fig 2_

Fig 3

5

Fig 4

7

6

5   5   5